# EUROPÄISCHE PATENTSCHRIFT

(11) **EP 1 195 005 B1**
(45) Veröffentlichungstag und Bekanntmachung des Hinweises auf die Patenterteilung: **02.04.2003**
(21) Anmeldenummer: 00931249.7
(22) Anmeldetag: 19.05.2000
(51) Int. Cl.: H03F 1/32

(54) **VORRICHTUNG UND VERFAHREN ZUM VORVERZERREN EINES ÜBER EINE NICHT-LINEARE ÜBERTRAGUNGSSTRECKE ZU ÜBERTRAGENDEN ÜBERTRAGUNGSSIGNALS**
DEVICE AND METHOD FOR PREDISTORTING A TRANSMISSION SIGNAL TO BE TRANSMITTED VIA A NONLINEAR TRANSMISSION PATH
DISPOSITIF ET PROCEDE POUR EFFECTUER UNE PREDISTORSION D'UN SIGNAL DE TRANSMISSION A TRANSMETTRE SUR UNE LIGNE DE TRANSMISSION NON LINEAIRE

(30) Priorität: 18.06.1999 DE 19927952
(43) Veröffentlichungstag der Anmeldung: 10.04.2002
(73) Patentinhaber: Fraunhofer-Gesellschaft zur Förderung der angewandten Forschung e.V., 80636 München (DE)
(72) Erfinder: PERTHOLD, Rainer, D-91085 Weisendorf (DE); HOFMANN, Maximilian, D-91058 Erlangen (DE); ROGALSKY, Ingo, D-91054 Erlangen (DE); GERHÄUSER, Heinz, D-91344 Waischenfeld (DE)
(74) Vertreter: Schoppe, Fritz, Dipl.-Ing.
(86) Internationale Anmeldenummer: EP0004580
(87) Internationale Veröffentlichungsnummer: WO00079679

(56) Entgegenhaltungen:
- EP-A- 0 121 446
- EP-A- 0 774 833
- EP-A- 0 844 732
- US-A- 3 732 502
- US-A- 4 276 514
- US-A- 5 113 414

## Beschreibung

Die vorliegende Erfindung bezieht sich auf eine Vorrichtung und ein Verfahren zum Vorverzerren von über eine nicht-lineare Übertragungsstrecke zu übertragenden Signalen, derart, daß der Einfluß von Störanteilen nach dem Übertragen über die nicht-lineare Übertragungsstrecke auf den Nutzanteil des übertragenen Signals optimiert werden kann. Die vorliegende Erfindung kann vorzugsweise Anwendung bei Sendern für den digitalen Rundfunk finden, die mit Signalen gespeist werden, die aus einer Vielzahl von Einzelträgern zusammengesetzt sind und zu einer nicht konstanten Hüllkurve eines hochfrequenten Trägersignals führen. Insbesondere bei derartigen Signalen verursacht die Nicht-Linearität des Leistungsverstärkers einer Endstufe des Senders unerwünschte Frequenzanteile des Signals am Ausgang des Leistungsverstärkers, die benachbarte Frequenzkanäle stören.

Werden in einem beispielsweise drahtlosen Kommunikationssystem Modulationsverfahren eingesetzt, die zu einer nichtkonstanten Hüllkurve des hochfrequenten Trägersignals führen, müssen alle Signalverarbeitungskomponenten nach dem Modulator eine hinreichende Linearität aufweisen. Diese Forderung ist besonders bei Leistungsverstärkerstufen, die mit einem guten Wirkungsgrad arbeiten sollen, schwer zu erfüllen.

Bei der Verwendung von Puls-Amplituden-Modulationsverfahren verschlechtert sich die spektrale Effizienz durch die Nichtlinearität der Verstärker. Der Grund dafür liegt in den nichtlinearen Amplitudenausgangscharakteristika eines Verstärkers, was zu.einer AM/AM-Konversion führt, wobei ferner das Driften der Phase eines Ausgangssignals eines Verstärkers bezüglich der Phase eines Eingangssignals Intermodulationskomponenten erzeugt, was auch als AM/PM-Konversion bezeichnet wird. Die AM/AM- und die AM/PM-Konversion müssen jedoch durch geeignete Linearisierungsverfahren unterbunden werden. Wird dies nicht durchgeführt, verschlechtert sich die spektrale Effizienz des eingesetzten Modulationsverfahrens sowie der Signal/Rausch-Abstand. In digitalen Übertragungssystemen kann sich dadurch die Bitfehlerrate bei der Übertragung wesentlich erhöhen.

Es besteht also ein Bedarf nach einem geeigneten Linearisierungsverfahren basierend auf der Vorverzerrung. Dieses könnte in allen Fällen Anwendung finden, in denen allgemein eine nichtlineare Übertragungsstrecke linearisiert werden soll. Die Linearisierung einer nichtlinearen Übertragungsstrecke sollte ferner zulassen, daß sich der Frequenzbereich des Eingangssignals in die zu entzerrende nichtlineare Übertragungsstrecke von dem Frequenzbereich des Ausgangssignales aus der nichtlinearen Übertragungsstrecke heraus unterscheiden kann. Die Linearisierung darf daher nicht auf reine Verstärkerstufen beschränkt sein, sondern es müssen auch Frequenzumsetzungen innerhalb der nichtlinearen Übertragungsstrecke vorgenommen werden können.

In der Technik existieren bereits mehrere Verfahren zum Linearisieren von Hochfrequenzendstufen. Die bekanntesten Verfahren zum Linearisieren von Hochfrequenzendstufen lassen sich folgendermaßen einordnen.

Bei der digitalen Vorverzerrung eines zu übertragenden Signales werden die digital dargestellten Werte des Signals mit geeignet gewählten Koeffizienten multipliziert. Die Vorverzerrung erfolgt somit zusammen mit dem digitalen Erzeugen des Steuersignals des Modulators. Ein Beispiel für digitale Vorverzerrung offenbart US-Patent Nr. 5, 113, 414.

Ein weiteres bekanntes Verfahren ist die analoge Vorverzerrung. Sie bedient sich nichtlinearer Bauteile, wie z.B. Schottky-Dioden, um eine zu der Verstärkerverzerrungkennlinie komplementäre Entzerrungskennlinie zu synthetisieren.

Die "kartesische Schleife" ("auch Cartesian Loop" genannt) stellt eine analoge Gegenkopplung der Hochfrequenzendstufe dar, welche im Basisband durchgeführt wird.

Die Vorwärtskopplung (in der Technik auch "Feedforward" genannt) stellt im Sinne der Regelungstechnik eine Störgrößenaufschaltung dar, wobei zu dem Ausgangssignal der Endstufe eine entsprechende Korrekturspannung addiert wird, um die Verzerrung der Endstufe zu kompensieren.

In der WO 93/18581 ist eine "Cartesian Loop" beschrieben, deren Parameter entsprechend verschiedener Systemparameter, die den aktuellen Betriebszustand des Systems wiederspiegeln, eingestellt werden. Ein Funksendegerät weist dabei einen Leistungsverstärker, eine Linearisierungseinrichtung und eine Rückkopplungseinrichtung zum Rückkoppeln eines Signals von einem Ausgang des Leistungsverstärkers zu der Linearisierungseinrichtung auf, um die Linearität des Ausgangssignals sicherzustellen. Die Linearisierungseinrichtung arbeitet im Basisband, wobei die IQ-Signale von einer linearen Steuerung gesteuert werden, welche mit einer Direktzugriffstabelle verbunden ist, welche vorbestimmte Schleifenlinearisierungsparameter speichert. Nachdem die IQ-Signale durch die Linearisierungseinrichtung geeignet verarbeitet worden sind, werden diese verarbeiteten Signale mittels eines Aufwärtsmischers hochgemischt und durch den Leistungsverstärker verstärkt. Die Rückkopplungseinrichtung nimmt ein Ausgangssignal des Leistungsverstärkers, mischt es mittels eines Abwärtsmischers herunter, und speist das heruntergemischte Signal in die Linearisierungseinrichtung ein. Die Linearisierung erfolgt daher nicht im Hochfrequenzbereich, sondern im Basisbandbereich, da auf die IQ-Signale zugegriffen wird. Ferner verwirklicht die beschriebene Schaltung eine dauerhafte Gegenkopplung der HF-Endstufe im Sinne einer Cartesian Loop.

Die GB 2240893 A offenbart eine Schaltung zur Linearisierung der Amplitudenantwort und der Phasenantwort eines Verstärkers. Eine Hüllkurvendetektorschaltung erfaßt die Hüllkurve eines zu übertragenden Eingangssignales, wobei das Ausgangssignal der Hüllkurvendetektorschaltung in eine Steuerschaltung vom nichtlinearen Typ sowie in eine Phasenschiebersteuerschaltung eingegeben wird. Die Phasenschiebersteuerschaltung steuert einen Phasenschieber, der vor dem Leistungsverstärker angeordnet ist, um das Hochfrequenzsignal phasenmäßig vorzuverzerren. Die Steuerschaltung vom nichtlinearen Typ liefert ein Eingangssignal in einen spannungsvariablen Gleichspannungs-Gleichspannungswandler, welcher die Vorspannungsparameter, d.h. den Arbeitspunkt des Leistungsverstärkers geeignet einstellt, um die Verzerrung des nichtlinearen Verstärkers zu kompensieren. Der Amplitudenfehler der Verstärkers wird daher über dessen Arbeitspunkteinstellung kompensiert, was den Nachteil besitzt, daß die Arbeitspunktparameter des Verstärkers ständig geändert werden müssen, was eine Anpassung des Verstärkers an eine Last wesentlich erschweren kann. Üblicherweise erfordert nämlich ein geänderter Arbeitspunkt automatisch ein anderes (komplexes) Transformationsverhältnis des Ausgangswiderstandes.

Das US-Patent Nr. 5,023,937 stellt eine analoge Vorverzerrungsschaltung für einen im nichtlinearen Bereich betriebenen Leistungsverstärker dar. Diese Vorverzerrung arbeitet mittels einer Gegenkopplungsschleife, bei der im Gegensatz zur Cartesian Loop nicht die IQ-Komponenten des Ausgangssignals geregelt werden, sondern der Betrag und die Phase desselben. Ein Hüllkurvendetektor erfaßt die Amplitude des zu verstärkenden Signals, welche durchgehend rückkopplungsmäßig mit der Hüllkurve des Ausgangssignals des Leistungsverstärkers verglichen wird, wobei das Vergleichsergebnis an ein variables Dämpfungsglied angelegt ist, das das Eingangssignal vor dem Leistungsverstärker geeignet dämpft, um ein möglichst lineares Ausgangssignal zu erzeugen. Die Phasenvorverzerrung wird mittels einer Phasenregelschleife durchgeführt, die als Eingangssignal das zu verstärkende Signal erhält. Ein Teil des Ausgangssignals des Verstärkers wird mittels eines Mischers, eines Lokaloszillators und einer Phasenschieberschaltung ebenfalls in die Phasenregelschleife eingegeben, welche ein Lokaloszillatorsignal für einen vor dem Leistungsverstärker angeordneten Mischer liefert, um das zu verstärkende Signal phasenmäßig geeignet vorzuverzerren. Diese Schaltung arbeitet vollständig analog und basiert auf einer im wesentlichen durchgehenden Rückkopplung, falls die vorhandene Phasenregelschleife eingerastet ist.

Das US-Patent Nr. 4,465,980 stellt ebenfalls eine analoge Vorverzerrungsschaltung dar. Ein Detektor erfaßt die Hüllkurve eines zu verstärkenden Signals und legt dieses Signal an einen Feldeffekttransistor mit zwei Gate-Anschlüssen ("Dual Gate FET") an. An das andere Gate des Dual-Gate-FET wird das zu verstärkende Signal angelegt. Durch geeignetes Steuern des Arbeitspunktes dieses Dual-Gate-FET wird das HF-Eingangssignal geeignet vorverzerrt, um die nichtlineare Verstärkung eines Leistungsverstärkers, der über ein Anpassungsnetzwerk mit dem Drain-Anschluß des Dual-Gate-FET verbunden ist, zu kompensieren.

Die DE 3312030 A1 offenbart einen Verstärker mit Vorverzerrungskompensation, welcher Vorverzerrungskomponenten verwendet, die von einem dem Verstärkungsbauteil ähnlichen Leistungsverstärkungsbauteil erzeugt werden, um eine wirksame Linearisierung zur wesentlichen Reduzierung aller Intermodulations-Verzerrungsprodukte zu erreichen. Ferner kann eine zusätzliche Rückkopplungsschaltung vorgesehen werden, um eine weitere Verringerung von Nichtlinearitäten zu erreichen.

Die EP 312261 A2 offenbart eine Linearitätskorrekturschaltung, die in einem Zwischenfrequenzbereich arbeitet, um eine geeignete Vorverzerrung in eine Amplitudenhüllkurve einzuführen, um die Nichtlinearität der Leistungsverstärkerstufen zu kompensieren. Ein Array von parallelen Stromquellen, von denen jede als Reaktion auf eine Vorverzerrung über einem entsprechenden Amplitudenband einstellbar ist, injiziert einen Strom ein, der ausreichend ist, um eine geeignete Differenzspannung an dem Ausgang einzuführen. Bei dieser Schaltung findet offensichtlich keine Phasenvorverzerrung statt.

Die EP 0 658 975 A1 bezieht sich auf ein Basisbandvorverzerrungssystem für die adaptive Linearisierung von Leistungsverstärkern und auf einen Funksender, der das Vorverzerrungssystem verwendet. Dabei werden zwei Fehlertabellen, und zwar eine für die Amplitude und eine für die Phase, aktualisiert, wobei der Inhalt derselben zum Korrigieren der Basisbandabtastwerte verwendet wird. Der Inhalt der Tabellen wird erhalten, indem eine geeignet gewichtete Differenz zwischen Abtastwerten, die in das Vorverzerrungsgerät eingegeben werden, und einem demodulierten Rückkopplungswert akkumuliert wird. Eine Vorverzerrung wird also ähnlich zu der WO93/1851, wie vorher beschrieben wurde, nicht im Hochfrequenzbereich, sondern digital im Basisband durchgeführt, wobei ein Zugriff auf die digitale Signalaufbereitung im Basisband vorhanden sein muß.

Eine digitale Vorverzerrung, wie sie in der EP 0 658 975 A1 und in der WO93/18581 beschrieben ist, bedingt eine Zugriffsmöglichkeit auf das Modulationssignal, bevor es von einer digitalen Darstellung in einen Analogspannungswert umgewandelt wird, um die erforderlichen digitalen Berechnungen zur Korrektur von Trägeramplitude und Trägerphase durchführen zu können. Dieser Zugriff ist in vielen Fällen nicht gegeben, da nur innerhalb des abgeschlossenen Systems der Leistungsendstufe linearisiert werden kann.

Bei der analogen Vorverzerrung des Hochfrequenzsignals ergibt sich das Problem, eine geeignete Kennlinie aus nichtlinearen Bauteilen synthetisieren zu müssen, welche Exemplarstreuungen, Temperaturdrift, Alterung usw. aufweisen. Bei Alterung der Bauteile kann sich die Nichtlinearität verstärken.

Die "Cartesian Loop", d.h. eine HF-Gegenkopplung, reagiert sehr empfindlich auf Parameterschwankungen. Durch die hohe Verstärkung besteht ferner eine erhebliche Schwingneigung der gesamten Anordnung bei nicht exakt ermittelten Parametern der Rückkopplung. Ebenfalls wird durch die Gegenkopplung das Rauschverhalten der Endstufe drastisch verschlechtert, da die Gegenkopplung ihrerseits unkorreliertes Rauschen in die Verstärkerstufe einführt.

Das "Feedforward"-Verfahren erfordert eine genaue Bestimmung der Signallaufzeiten der Endstufe. Die Linearitätsanforderungen an das Korrektursignal sind hoch, weshalb bei einer Schaltung, die eine Linearisierung gemäß dem Vorwärtskopplungsverfahren durchführt, hochwertige und teure Leistungsverstärker eingesetzt werden müssen.

Aus dem Artikel "Reduktion von Nachbarkanalstörungen in OFDM-Funkübertragungssystemen von Thomas May, Hermann Rohling, TU Braunschweig, Schleinitzstraße 22, 38092 Braunschweig, ist ferner ein Verfahren zur additiven Korrektur eines OFDM-Signals bekannt. Bei diesem Verfahren wird das OFDM-Basisbandsignal mittels einer geeigneten Hilfsfunktion korrigiert, um durch einen nachgeschalteten Verstärker bewirkten Nicht-Linearitäten zu begegnen. Bei der Hilfsfunktion handelt es sich dabei um eine geeignet angepaßte si-Funktion, die bewirkt, daß keine Nachbarkanalstörungen verursacht werden, da sich die Störleistung auf die OFDM-Bandbreite konzentriert, so daß praktisch keine Außerbandstrahlung entsteht.

Aus der DE 19631388 A1 ist ferner ein System zur Vorverzerrung für eine nicht-lineare Übertragungsstrecke im Hochfrequenzbereich bekannt, bei dem die Hüllkurve eines über eine nicht-lineare Übertragungsstrecke zu übertragenden Signals erfaßt wird, woraufhin quantisierte Hüllkurvenwerte gebildet werden. In einer Tabelleneinrichtung sind komplexe Vorverzerrungskoeffizienten gespeichert, die von den quantisierten Hüllkurvenwerten und von einer vorab erfaßten Übertragungsfunktion der nicht-linearen Übertragungsstrecke abhängen. Ferner ist eine Bewertungseinrichtung vorgesehen, beispielsweise ein IQ-Modulator, durch die das zu übertragende Signal vor dem Übertragen desselben über die nicht-lineare Übertragungsstrecke mit den komplexen Vorverzerrungskoeffizienten moduliert wird, derart, daß die durch die nicht-lineare Übertragungsstrecke verursachte Verzerrung nach Betrag und Phase weitgehend kompensiert ist. Es hat sich jedoch gezeigt, daß mit diesem System eine vollständige Kompensation kaum erreicht werden kann, wobei noch Störanteile unmittelbar benachbart zu dem Nutzkanal des Übertragungssignals verbleiben. Somit sind hier hohe Anforderungen an ein der nicht-linearen Übertragungsstrecke nachzuschaltendes Bandpaßfilter zu stellen.

Bei der Mehrzahl der oben beschriebenen bekannten Verfahren zum Linearisieren von Hochfrequenzendstufen wird versucht, die Nicht-Linearität des Verstärkers in ihrer Auswirkung zu reduzieren, indem dem Verstärker ein entsprechend vorverzerrtes Eingangssignal geboten wird. Auf diese Weise wird ein nicht-lineares Verhalten der Kombination Vorverzerrer/Verstärker innerhalb des zulässigen Aussteuerbereichs erreicht. Die bekannten Vorverzerrer sind gedächtnislos. Sobald der Verstärker für kurze Zeit so stark ausgesteuert werden soll, daß er als Begrenzer wirkt, wird die Vorverzerrung wirkungslos. Bei den überdies beschriebenen Feed-Forward-Verfahren handelt es sich, wie bereits erwähnt, aus regelungstechnischer Sicht um eine Störgrößenaufschaltung, wobei nachteilig ist, daß zur Erzeugung des Korrektursignals ein Verstärker mit einer ähnlich großen Leistungsfähigkeit wie der des zu linearisierenden Verstärkers erforderlich ist.

Bei Eingangssignalen mit großem Spitzenwertfaktor, wie sie beispielsweise bei Mehrträgerverfahren auftreten, versagen die bekannten Verfahren, da der Leistungsverstärker kurzzeitig vollständig in die Begrenzung geht.

Die Aufgabe der vorliegenden Erfindung besteht darin, eine neuartige Vorrichtung und ein neuartiges Verfahren zum Vorverzerren eines über eine nicht-lineare Übertragungsstrecke zu übertragenden Übertragungssignals zu schaffen, die eine solche Vorverzerrung des übertragenden Signals ermöglichen, daß der Einfluß von durch eine nicht-lineare Übertragungsstrecke verursachten Störanteilen auf den Nutzanteil des zu übertragenden Signals minimiert werden kann, und ferner, einen Hochfrequenzsender und ein Verfahren zur spektralen Formung eines Störspektrums eines Übertragungssignals unter Verwendung einer derartigen Vorrichtung bzw. eines derartigen Verfahrens zu schaffen.

Diese Aufgabe wird durch eine Vorrichtung nach Anspruch 1, einen Hochfrequenzsender nach Anspruch 10 und Verfahren nach den Ansprüchen 11 und 12 gelöst.

Die vorliegende Erfindung schafft eine Vorrichtung zum Vorverzerren eines über eine nicht-lineare Übertragungsstrecke zu übertragenden Übertragungssignals, die eine Schätzeinrichtung zur Ermittlung eines Fehlersignals abhängig von dem Übertragungssignal und einer vorab erfaßten Übertragungscharakteristik der nicht-linearen Übertragungsstrecke aufweist. Das Fehlersignal stellt eine Abschätzung eines durch die Nicht-Linearität der Übertragungsstrecke erzeugten Fehlers dar. Ein zeitdispersives Element ist vorgesehen, um durch eine zeitliche Aufweitung des Fehlersignals ein Korrektursignal zu erzeugen. Das Korrektursignal wird in einer Kombinierungseinrichtung mit dem Übertragungssignal kombiniert. Durch die zeitliche Aufweitung des Fehlersignals wird bewirkt, daß ein Fehlersignalanteil in dem Frequenzspektrum eines von der nicht-linearen Übertragungsstrecke übertragenen Übertragungssignals von dem Nutzfrequenzbereich des Übertragungssignals weg verschoben wird.

Die vorliegende Erfindung unterscheidet sich von bekannten Lösungsansätzen dadurch, daß nicht versucht wird, das Begrenzen des Verstärkers zu vermeiden, indem derselbe linearisiert wird. Vielmehr wird die spektrale Verteilung der entstehenden Störung derart verändert, daß sie durch ein dem Verstärker nachgeschaltetes Bandpaßfilter ohne weiteres reduziert bzw. minimiert werden kann. Durch die erfindungsgemäße Vorverzerrung wird somit eine spektrale Formung des Störspektrums am Ausgang einer nicht-linearen Übertragungsstrecke bewirkt. Die vorliegende Erfindung eignet sich insbesondere zum Einsatz in Sendern, mit denen durch Mehrträgerverfahren modulierte Signale übertragen werden, wie z.B. Sendern für den digitalen Rundfunk, wobei in derartigen Sendern das oben erwähnte Bandpaßfilter am Ausgangs des Leistungsverstärkers in aller Regel bereits vorhanden ist.

Erfindungsgemäß wird diese Formung des Störspektrums am Ausgang einer nicht-linearen Übertragungsstrecke erreicht, indem zunächst eine Abschätzung des Fehlersignals, das durch die nicht-lineare Übertragungsstrecke bewirkt wird, durchgeführt wird, woraufhin das abgeschätzte Fehlersignal vor der Kombination desselben mit dem zu übertragenden Signal einer zeitlichen Aufweitung unterzogen wird. Durch diese zeitliche Aufweitung werden Störsignalanteile im Frequenzspektrum des Ausgangssignals der nicht-linearen Übertragungsstrecke in einen gewünschten Spektralbereich verschoben, der beabstandet von dem Frequenzbereich des Nutzsignals ist.

Die vorliegende Erfindung eignet sich insbesondere zur Vorverzerrung von einer Mehrträgermodulation unterzogenen Signalen, kann jedoch auch für andere Signale, beispielsweise CDMA-Signale, verwendet werden, die hohe Spitzenwertfaktoren aufweisen.

Die vorliegende Erfindung ermöglicht zum einen, daß das Fehlersignal am Ausgang der nicht-linearen Übertragungsstrecke eine möglichst geringe Energie aufweist, und zum anderen, daß die verbleibende Energie des Fehlersignals in einem gewünschten, bezüglich des Frequenzbereichs des Nutzsignals verschobenen, Spektralbereich auftritt. Somit ermöglicht die vorliegende Erfindung durch die Verwendung eines Bandpaßfilters am Ausgang der nicht-linearen Übertragungsstrecke ein Übertragungssignal, dessen Nutzanteil im wesentlichen frei von durch Nicht-Linearitäten der nicht-linearen Übertragungsstrecke bewirkten Störanteilen ist.

Das Abschätzen des Fehlersignals, das eine Abschätzung eines durch die Nicht-Linearität der Übertragungsstrecke erzeugten Fehlers darstellt, kann auf unterschiedliche Arten erfolgen. Beispielsweise können jeweils Betragsquadratwerte des zu übertragenden Übertragungssignals gebildet werden. Auf der Grundlage dieser Betragsquadratwerte kann dann auf eine Tabelle zugegriffen werden, in der komplexe Verzerrungskoeffizienten gespeichert sind, die von den Betragsquadratwerten und den vorab erfaßten Übertragungscharakteristika der nicht-linearen Übertragungsstrecke abhängen. Die entsprechenden Verzerrungskoeffizienten werden dann mit dem zu übertragenden Übertragungssignal kombiniert, um das Fehlersignal zu erzeugen. Alternativ kann ein Hüllkurvendetektor zum Erfassen der Hüllkurve des Übertragungssignals und eine Quantisierungseinrichtung zum Bilden quantisierter Hüllkurvenwerte vorgesehen sein. Auf der Grundlage der quantisierten Hüllkurvenwerte wird dann wiederum auf eine Tabelle, in der komplexe Verzerrungskoeffizienten gespeichert sind, zugegriffen.

Bei dem zeitdispersiven Element handelt es sich erfindungsgemäß vorzugsweise um ein zeitdispersives Bandpaßfilter oder Tiefpaßfilter, in dem kurze Störimpulse in längere Störimpulse umgeformt werden, um eine zeitliche Aufweitung des Fehlersignals zu bewirken. Diese Aufweitung bedingt dann die oben beschriebene spektrale Formung des Störspektrums am Ausgang der nicht-linearen Übertragungsstrecke.

Die Filterkoeffizienten des zeitdispersiven Bandpaßfilters oder Tiefpaßfilters können vorzugsweise vorab aus der Übertragungscharakteristik der nicht-linearen Übertragungsstrecke ermittelt werden, indem beispielsweise die spektrale Leistung des durch die nicht-lineare Übertragungsstrecke übertragenen Signals gemessen wird, und die Leistung in den zu dem Nutzfrequenzbereich benachbarten Gebieten dann als Optimierungskriterien für die Filterkoeffizienten verwendet wird. Zur Optimierung der Filterkoeffizienten können bekannte Algorithmen, beispielsweise der Simplex-Algorithmus verwendet werden. Neben dem als bevorzugtes Ausführungsbeispiel verwendeten zeitdispersiven Bandpaßfilter oder Tiefpaßfilter können in gleicher Weise andere zeitdispersive Elemente verwendet werden, die eine zeitliche Aufweitung des abgeschätzten Fehlersignals bewirken.

Bei bevorzugten Ausführungsbeispielen der vorliegenden Erfindung werden die Übertragungscharakteristika der nicht-linearen Übertragungsstrecke außerhalb des Betriebs der Vorverzerrungsvorrichtung bestimmt, um diese dann beim Betrieb zur Einstellung der Schätzeinrichtung und/oder des zeitdispersiven Elements zu verwenden. Um zu bestimmten Zeitpunkten während des Betriebs der Vorverzerrungsvorrichtung eine Feinabstimmung durchführen zu können, kann erfindungsgemäß eine Adaptionseinrichtung vorgesehen sein, um die komplexen Korrekturkoeffizienten für die Schätzeinrichtung bzw. die Filterkoeffizienten für das zeitdispersive Filter an die jeweiligen tatsächlichen Gegebenheiten anzupassen.

Die vorliegende Erfindung liefert eine Reihe von Vorteilen gegenüber bekannten Vorverzerrungssystemen. Zum einen kann die gesamte Signalverarbeitung digital vorgenommen werden, so daß keine Probleme mit Bauteiltoleranzen oder Abgleich auftreten. Ferner muß nicht in den Hochfrequenzteil, d.h. den Leistungsverstärker bzw. das demselben nachgeschaltete Bandpaßfilter, eingegriffen werden. Die erfindungsgemäß bewirkte Reduzierung der Nebenaussendungen ermöglicht wesentliche Kosteneinsparungen bei dem Leistungsverstärker sowie der Stromversorgung desselben, da beide kleiner ausgelegt werden können. Überdies sinken die Anforderungen an das nachgeschaltete Bandpaßfilter, was ebenfalls die Kosten reduziert. Die vorliegende Erfindung ermöglicht gegenüber klassischen Linearisierungsverfahren wesentlich höhere Linearisierungsgewinne im Bereich von 20 dB verglichen mit Linearisierungsgewinnen von 5 bis 8 dB bei klassischen Linearisierungsverfahren.

Bevorzugte Ausführungsbeispiele der vorliegenden Erfindung wird nachfolgend bezugnehmend auf die beiliegenden Zeichnungen näher erläutert. Es zeigen:
- Fig. 1: ein schematisches Blockdiagramm eines Senders, bei der die erfindungsgemäße Vorverzerrungsvorrichtung verwendet ist;
- Fig. 2: ein schematisches Blockdiagramm, das ein Ausführungsbeispiel einer Schätzeinrichtung zeigt;
- Fig. 3 und 4: Zeitverläufe von bei Durchführung der erfindungsgemäßen Vorverzerrung auftretenden Signalen; und
- Fig. 5 und 6: Leistungsspektren von bei Durchführung der erfindungsgemäßen Vorverzerrung auftretenden Signalen.

Im folgenden wird bezugnehmend auf einen Sender, der einen Hochfrequenz-Leistungsverstärker verwendet, ein bevorzugtes Ausführungsbeispiel der vorliegenden Erfindung erläutert. Es ist jedoch klar, daß die vorliegende Erfindung auch zur Vorverzerrung von Signalen verwendet werden kann, die über andere nichtlineare Übertragungsstrecken übertragen werden.

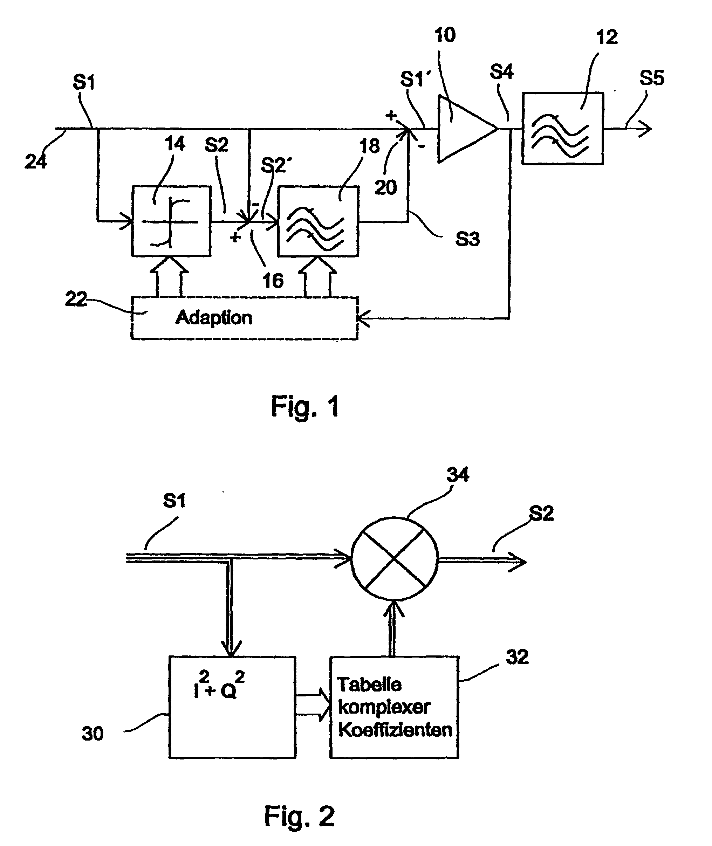

In Fig. 1 ist ein Sender dargestellt, der beispielsweise für den digitalen Rundfunk einsetzbar ist. Dem Sender wird ein Eingangssignal S1 zugeführt, das beispielsweise ein Mehrträgersignal mit einer nichtkonstanten Hüllkurve ist. Ohne Vorverzerrung würde dieses Eingangssignal S1 direkt einem Leistungsverstärker 10, dem ein schmales Bandpaßfilter 12 nachgeschaltet ist, zugeführt werden. Um jedoch Nichtlinearitäten des Leistungsverstärkers 10, der eine nichtlineare Übertragungsstrecke darstellt, zu kompensieren, wird zunächst eine Vorverzerrung des Eingangssignals S1 durchgeführt. Zu diesem Zweck wird das Eingangssignal S1 zunächst einer Nachbildungseinrichtung 14 zugeführt, die das nichtlineare Verhalten des Leistungsverstärkers 10, d.h. eine AM/AM- und eine AM/PM-Konversion, nachbildet. Am Ausgang der Nachbildungseinrichtung 14 wird somit ein Signal S2 erhalten, das eine Abschätzung des tatsächlich von dem Leistungsverstärker 10 ausgegebenen Signals, wenn als Eingangssignal das Signal S1 an denselben angelegt wird, darstellt. Beispiele für die Nachbildungseinrichtung 14 werden nachfolgend beispielsweise bezugnehmend auf Fig. 2 erläutert.

Der Ausgang der Nachbildungseinrichtung 14 ist bei dem dargestellten Ausführungsbeispiel mit einer Kombinierungseinrichtung verbunden, die in Fig. 1 schematisch bei 16 gezeigt ist. Die Nachbildungseinrichtung 14 und die Kombinierungseinrichtung 16 bilden bei dem dargestellten Ausführungsbeispiel die Schätzeinrichtung des erfindungsgemäßen Vorverzerrers. In der Kombinierungseinrichtung werden das Eingangssignal S1 und das Schätzsignal kombiniert, derart, daß am Ausgang der Kombinierungseinrichtung 16 ein Fehlersignal S2' vorliegt, das eine Abschätzung des durch den Leistungsverstärker 10 eingeführten Fehlers darstellt. Bei dem dargestellten Ausführungsbeispiel wird dabei das Eingangssignal S1 von dem Schätzsignal S2 abgezogen. Der Ausgang der Kombinierungseinrichtung 16 ist mit dem Eingang eines zeitdispersiven Filters 18 verbunden. Durch das zeitdispersive Filter 18 wird aus dem Fehlersignal S2' durch eine zeitliche Aufweitung desselben ein Korrektursignal S3 erzeugt. Dieses Korrektursignal S3 wird in einer weiteren Kombinierungseinrichtung, die in Fig. 1 schematisch bei 20 gezeigt ist, mit dem Eingangssignal S1 kombiniert. Bei dem dargestellten Ausführungsbeispiel wird das Korrektursignal S3 von dem Eingangssignal S1 subtrahiert. Ob im Kombinierungselement eine Subtraktion oder eine Addition stattfindet, hängt von den Filterkoeffizienten des zeitdispersiven Bandpaßfilters oder Tiefpaßfilters 18 ab.

Der Ausgang der Kombinierungseinrichtung 20 ist mit dem Eingang des Leistungsverstärkers 10 verbunden. Der Leistungsverstärker 10 verstärkt somit das vorverzerrte Signal S1', das durch Kombination des Eingangssignals S1 und des Korrektursignals S3 gebildet wird. Am Ausgang des Leistungsverstärkers 10 liegt ein Signal S4 vor, das dann einer Bandpaßfilterung durch das Bandpaßfilter 12 unterzogen wird, um das Ausgangssignal S5 des Senders zu erzeugen.

Wie ferner in Fig. 1 gezeigt ist, kann optional eine Adaptionsvorrichtung 22 vorgesehen sein, die das von dem Leistungsverstärker 10 ausgegebene Signal S4 abgreift, um basierend darauf Übertragungscharakteristika des Leistungsverstärkers 10 zu bestimmen und zur Adaption der Nachbildungseinrichtung 14 bzw. des zeitdispersiven Bandpaßfilters oder Tiefpaßfilters 18 zu verwenden. Ferner können in dem direkten Signalweg von dem Eingang 24 des Senders zu der Kombinierungseinrichtung 20 geeignete Verzögerungsglieder vorgesehen sein, um die von vornherein festliegende Verzögerungszeit der erfindungsgemäßen Vorverzerrung zu kompensieren. Die Vorverzerrung wird vorzugsweise durch einen externen Takt synchronisiert, so daß die Verzögerungszeit nicht von irgendwelchen Parametern abhängig ist. Somit ist eine Kompensation der Verzögerungszeit auf einfache Art und Weise durch Vorsehen geeigneter Verzögerungsglieder in der direkten Verbindung zwischen dem Eingang 24 und der Kombinierungseinrichtung 20 möglich.

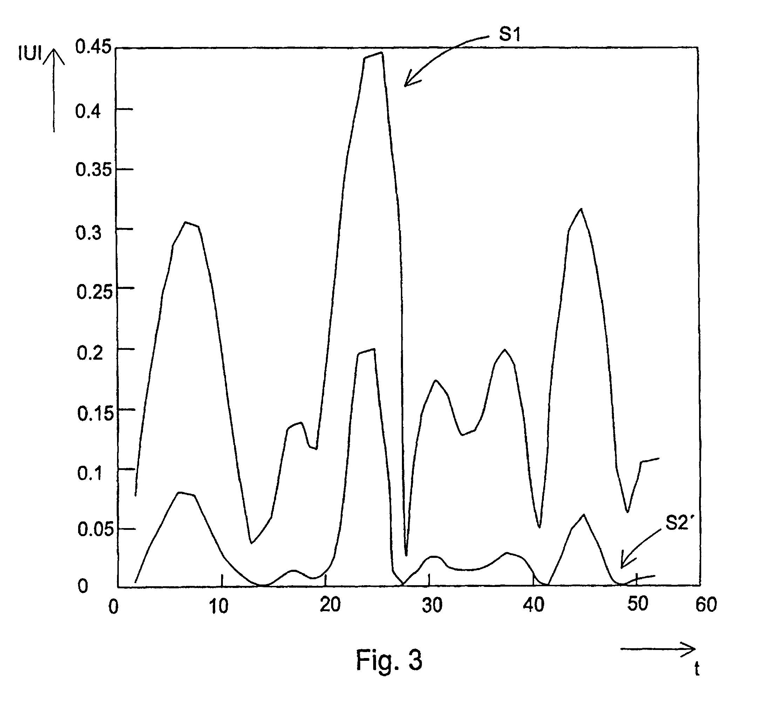

Bevor auf die Funktionsweise des in Fig. 1 dargestellten Vorverzerrers bezugnehmend auf die Fig. 3 bis 6 näher eingegangen wird, wird zunächst bezugnehmend auf Fig. 2 ein bevorzugtes Ausführungsbeispiel für die Nachbildungseinrichtung 14 beschrieben.

Bei dem bevorzugten Ausführungsbeispiel weist die Nachbildungseinrichtung 14 eine Betragsquadratbildungseinrichtung 30 auf, der das Eingangssignal S1 zugeführt wird. Die Betragsquadratbildungseinrichtung 30 bildet die Summe der Betragsquadrate aus Realteil I² und Imaginärteil Q² des Eingangssignals S1. Auf der Grundlage dieser Betragsquadrate wird dann auf eine Tabelle 32 komplexer Koeffizienten zugegriffen, in der den Betragsquadraten bzw. der Betragsquadratsumme zugeordnete komplexe Koeffizienten gespeichert sind. Mit diesen komplexen Koeffizienten wird dann das Eingangssignal S1 in einem komplexen Multiplizierer 34 komplex multipliziert. Der komplexe Multiplizierer 34 kann beispielsweise ein IQ-Modulator sein. Am Ausgang des komplexen Multiplizierers 34 liegt das Schätzsignal S2 vor.

Die komplexen Koeffizienten der Tabelle 32 werden auf der Grundlage der Übertragungscharakteristik des Leistungsverstärkers 10 außerhalb des Betriebs der Schaltung berechnet und abgespeichert. Die in Fig. 2 dargestellte Schaltung simuliert somit die Übertragungscharakteristik des Leistungsverstärkers 10, so daß das Signals S2 eine Abschätzung des Signals darstellt, das durch den Leistungsverstärker 10 bei Speisung desselben mit einem nichtvorverzerrten Eingangssignal S1 erhalten werden würde. Um nun ein Fehlersignal, das eine Abschätzung des durch den Leistungsverstärker 10 erzeugten Fehlers darstellt, wird das Signal S2 mit dem Signal S1 kombiniert, so daß die Nachbildungseinrichtung 14 zusammen mit der Kombinierungseinrichtung 16 als eine Schätzeinrichtung zum Abschätzen des Fehlersignals betrachtet werden kann.

Alternativ können die komplexen Koeffizienten in der Tabelle derart eingestellt sein, daß durch Multiplikation derselben mit dem zu übertragenden Signal direkt ein Signal ausgegeben wird, das den von dem Leistungsverstärker 10 verursachten Fehler angibt, und somit dem Fehlersignal S2' entspricht.

Alternativ zu der oben beschriebenen Betragsquadratbildungseinrichtung kann eine Hüllkurvenerfassungseinrichtung und eine Quantisierungseinrichtung zum Bilden von quantisierten Hüllkurvenwerten aus der erfaßten Hüllkurve vorgesehen sein. In diesem Fall wird dann auf der Grundlage der quantisierten Hüllkurvenwerte auf die Tabelle komplexer Koeffizienten zugegriffen. Die Hüllkurvenerfassungseinrichtung kann beispielsweise ein Diodengleichrichter sein, während die Quantisierungseinrichtung beispielsweise ein Analog/Digital-Wandler sein kann.

Die in Fig. 1 dargestellt Adaptionsvorrichtung 22 kann dazu dienen, sowohl die Koeffizienten des Filters 18 als auch die komplexen Koeffizienten der Tabelle 32 adaptiv zu gewinnen. Als Optimierungskriterium zum Optimieren der Filterkoeffizienten des zeitdispersiven Filters kann die Leistung der Nebenaussendungen in dem gewünschten Frequenzbereich herangezogen werden. Zur Erzeugung der komplexen Koeffizienten für die Tabelle 32 der Nachbildungseinrichtung 14 kann das Ausgangssignal des Leistungsverstärkers 10, wenn die Vorverzerrungeinrichtung nicht aktiv ist, verwendet werden. Die Filterkoeffizienten des zeitdispersiven Filters 18 können ebenfalls bei deaktiver Vorverzerrungsschaltung oder zumindest deaktivem zeitdispersiven Filter aus den Ausgangssignalen des Leistungsverstärkers 10 und den zugehörigen Eingangssignalen ermittelt werden. Dazu kann eine Umgehung des zeitdispersiven Filters 18 vorgesehen sein.

Die Adaptionseinrichtung 22 kann ferner ausgestaltet sein, um zu bestimmten Zeitpunkten während des Betriebs eine Feinabstimmung der komplexen Koeffizienten bzw. der Filterkoeffizienten durchführen zu können. Dazu kann optional eine Vergleichseinrichtung vorgesehen sein, die das Eingangssignal S1 und das Ausgangssignal S4 vergleicht, um festzustellen, ob zwischen denselben ein linearer Zusammenhang, beispielsweise eine einfache Verstärkung, besteht. Sollte kein linearer Zusammenhang vorhanden sein, deutet dies darauf hin, daß sich Umgebungsbedingungen verändert haben, weswegen die Verzerrungskoeffizienten nicht mehr optimal eingestellt sind. In einem Neukalibrierungsschritt kann dann die Adaptionseinrichtung auf die Nachbildungseinrichtung 14 sowie das zeitdispersive Filter 18 zugreifen, um die komplexen Koeffizienten in der Tabelle 32 und/oder die Filterkoeffizienten des zeitdispersiven Filters 18 entsprechend den neuen Umgebungsbedingungen geeignet zu modifizieren.

Im folgenden wird nun die Wirkungsweise der in Fig. 1 dargestellten Schaltung bezugnehmend auf die Signalverläufe in den Fig. 3 bis 6 näher erläutert.

Fig. 3 zeigt den Zeitverlauf der Einhüllenden |U| eines typischen Mehrträgersignals, das das Eingangssignal S1 darstellt, wobei die Beschriftung der Zeitachse Abtastwerte darstellt. Wie Fig. 3 zu entnehmen ist, weist das Eingangssignal S1 einen hohen Spitzenwertfaktor auf, der bei einer normalen Betriebsweise des Leistungsverstärkers 10 groß genug ist, um den Verstärker vollständig in die Begrenzung zu bringen, so daß eine herkömmliche Linearisierung wirkungslos ist.

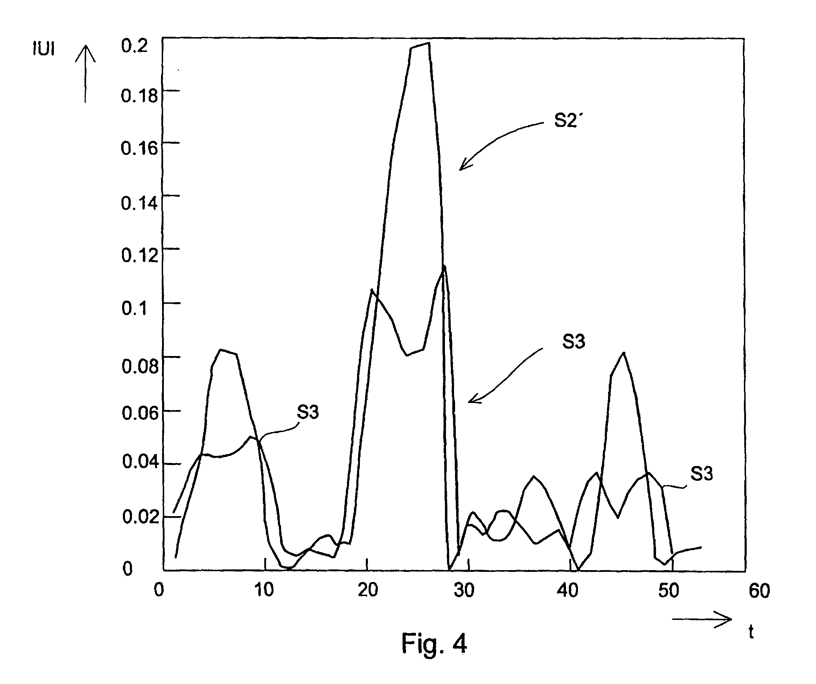

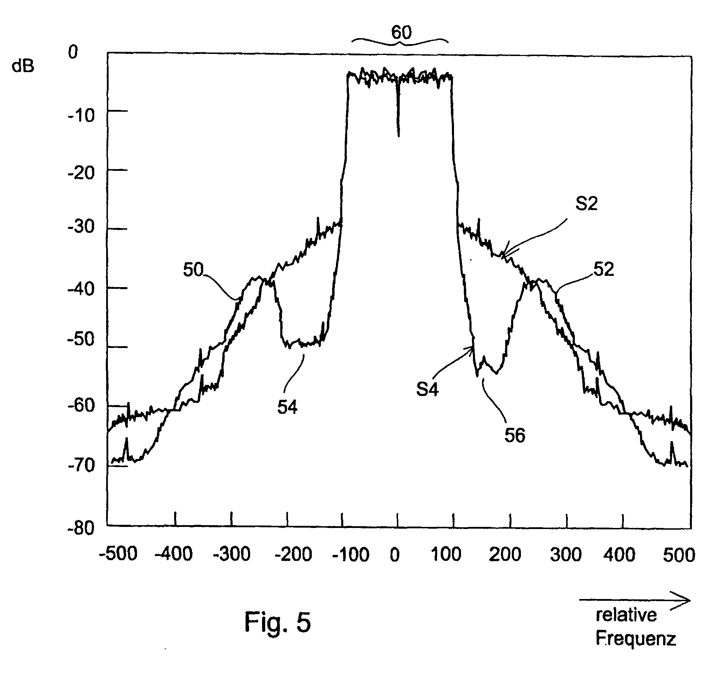

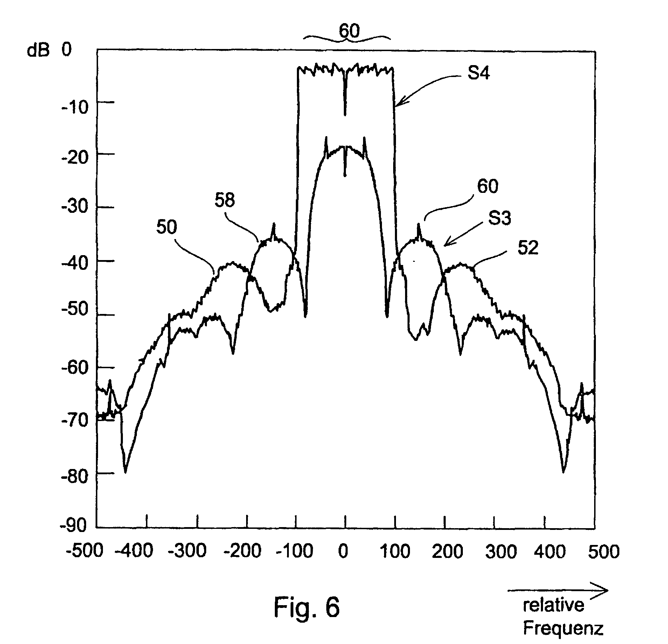

Aus diesem Eingangssignal S1 wird durch die Nachbildungseinrichtung 14 und die Kombinierungseinrichtung 16, die zusammen die Schätzeinrichtung bilden, ein Signal S2-S1 erzeugt, dessen Zeitverlauf ebenfalls in Fig. 3 dargestellt ist und das das Fehlersignal S2' darstellt. Dieses Fehlersignal S2' ist nochmals in Fig. 4 etwas vergrößert dargestellt. Das Fehlersignal S2' wird dem zeitdispersiven Element zugeführt, in dem eine zeitliche Aufweitung desselben stattfindet, so daß das Signal S3, das in Fig. 4 gezeigt ist, erzeugt wird. Wie deutlich Fig. 4 zu entnehmen ist, ist das Signal S3 hinsichtlich des Fehlersignals S2' zeitlich aufgeweitet. Dieses Korrektursignal S3 wird nun, wie bereits oben beschrieben wurde mit dem Eingangssignal S1 kombiniert, um ein vorverzerrtes Eingangssignal S1' zu erzeugen. Dieses vorverzerrte Eingangssignal S1' wird dann dem nichtlinearen Leistungsverstärker 10 zugeführt, wobei das Spektrum des Ausgangssignals S4 desselben in Fig. 5 dargestellt ist. Auf der waagerechten Achse in Fig. 5, wie auch in Fig. 6, ist die relative Frequenz bezüglich der Mittelfrequenz eines Nutzkanals aufgetragen.

In Fig. 5 ist nun zum Vergleich das Spektrum des Signals S2 dargestellt, das ohne Vorverzerrung am Ausgang des Leistungsverstärkers 10 erhalten werden würde. Aus Fig. 5 ist deutlich die verringerte und anders verteilte Störleistung des Signals S4 außerhalb des Nutzbereichs 60 im Vergleich zum Signal S2 zu erkennen. Bei dem dargestellten Ausführungsbeispiel liegt der Nutzbereich zwischen den relativen Frequenzen von etwa -100 und etwa 100. Von diesem Nutzbereich sind die verbliebenen Störanteile 50 und 52 des Signals S4 beabstandet, wie durch die Bereiche 54 und 56 zu erkennen ist. Diese Verschiebung der Störanteile 50 und 52 von dem Nutzbereich weg wird durch die zeitliche Aufweitung des Fehlersignals S2', um das Korrektursignal S3 zu erzeugen, erreicht. Dies ist insbesondere aus Fig. 6 zu erkennen, in der wiederum das Spektrum des Signals S4 und überdies das Spektrum des Korrektursignals S3 dargestellt ist. Wie zu erkennen ist, weist das Spektrum des Korrektursignals S3 im Bereich der Kanäle, die unmittelbar benachbart zu dem Nutzkanal 60 sind, Keulen 58 und 60 auf, so daß bei Subtraktion des Signals S3 von dem Eingangssignal S1 in diesen Bereichen eine erhöhte Dämpfung auftritt. Dadurch ergibt sich eine Verschiebung der Störanteile 50 und 52 von dem Nutzfrequenzbereich weg.

Die Verschiebung der Störanteile 50 und 52 von dem Nutzfrequenzbereich weg hat zur Folge, daß nachgeschaltet zu dem Leistungsverstärker 10 ein Bandpaßfilter 12 verwendet werden kann, an dessen Durchlaßcharakteristik geringere Anforderungen zu stellen sind, als wenn die Störsignalanteile direkt neben dem Nutzfrequenzbereich angeordnet wären. Durch die beschriebene Verschiebung der Störsignalenergie in einen gewünschten, von dem Nutzfrequenzbereich beabstandeten Spektralbereich sowie die Minimierung der Energie des Fehlersignals am Ausgang des Leistungsverstärkers durch die Abschätzung des Fehlers mittels der Schätzeinrichtung ermöglicht die vorliegende Erfindung somit die Herstellung von kostengünstigen Sendern, da zum einen sowohl der Leistungsverstärker als auch die Stromversorgung desselben entsprechend kleiner ausgelegt werden können und zum anderen ein Bandpaßfilter mit geringen Anforderungen verwendet werden kann.

## Patentansprüche

1. Vorrichtung zum Vorverzerren eines über eine nichtlineare Übertragungsstrecke (10) zu übertragenden Übertragungssignals (S1), mit folgenden Merkmalen:
einer Schätzeinrichtung (14, 16) zur Ermittlung eines Fehlersignals (S2') abhängig von dem Übertragungssignal (S1) und einer vorab erfaßten Übertragungscharakteristik der nichtlinearen Übertragungsstrecke (10), wobei das Fehlersignal (S2') eine Abschätzung eines durch die Nichtlinearität der Übertragungsstrecke (10) erzeugten Fehlers darstellt;
einem zeitdispersiven Element (18) zum Erzeugen eines Korrektursignals (S3) durch eine zeitliche Aufweitung des Fehlersignals (S2'); und
einer Kombinierungseinrichtung zum Kombinieren des Übertragungssignals (S1) und des Korrektursignals (S3),
wobei durch die zeitliche Aufweitung des Fehlersignals (S2') bewirkt wird, daß ein Fehlersignalanteil (50, 52) in dem Frequenzspektrum eines von der nichtlinearen Übertragungsstrecke (10) übertragenen Übertragungssignals (S4) von dem Nutzfrequenzbereich (60) des Signals weg verschoben wird.

2. Vorrichtung nach Anspruch 1, bei der die nichtlineare Übertragungsstrecke (10) ein Leistungsverstärker ist.

3. Vorrichtung nach Anspruch 1 oder 2, bei der die Schätzeinrichtung (14, 16) eine Betragsquadratbildungseinrichtung (30) zum Bilden von Betragsquadratwerten des zu übertragenden Übertragungssignals (S1) und eine Tabelle (32) zum Liefern von komplexen Verzerrungskoeffizienten, die von den Betragsquadratwerten und der vorab erfaßten Übertragungscharakteristik der nichtlinearen Übertragungsstrecke (10) abhängen, aufweist.

4. Vorrichtung nach Anspruch 3, bei der die Betragsquadratbildungseinrichtung (30) zum Bilden der Betragsquadrate von Realteil und Imaginärteil des Übertragungssignals vorgesehen ist.

5. Vorrichtung nach Anspruch 1 oder 2, bei der die Schätzeinrichtung einen Hüllkurvendetektor zum Erfassen der Hüllkurve des Übertragungssignals, eine Quantisierungseinrichtung zum Bilden quantisierter Hüllkurvenwerte und eine Tabelleneinrichtung zum Liefern von komplexen Verzerrungskoeffizienten, die von den quantisierten Hüllkurvenwerten und von der vorab erfaßten Übertragungscharakteristik der nichtlinearen Übertragungsstrecke abhängen, aufweist.

6. Vorrichtung nach einem der Ansprüche 3 bis 5, bei der die Schätzeinrichtung ferner ferner eine Einrichtung zum Kombinieren der Betragsquadratwerte oder der Hüllkurvenwerte und der komplexen Koeffizienten zum Erzeugen des Fehlersignals (S2') aufweist.

7. Vorrichtung nach einem der Ansprüche 1 bis 6, bei der das zeitdispersive Element (18) ein zeitdispersives Bandpaßfilter oder Tiefpaßfilter ist.

8. Vorrichtung nach Anspruch 7, bei der eine Adaptionseinrichtung (22) vorgesehen ist, die basierend auf einem zu übertragenden Signal und einem von einer nichtlinearen Übertragungsstrecke (10) ausgegebenen Ausgangssignal, wenn keine Vorverzerrung durchgeführt wird, die Übertragungscharakteristik der nichtlinearen Übertragungsstrecke (10) ermittelt und basierend darauf die Schätzeinrichtung und/oder die Filterkoeffizienten des zeitdispersiven Bandpaßfilters oder Tiefpaßfilters (18) steuert.

9. Vorrichtung nach Anspruch 8, bei der die Adaptionseinrichtung (22) die Übertragungscharakteristik zu vorgegebenen Zeitpunkten ermittelt.

10. Hochfrequenzsender mit folgenden Merkmalen:
einer Vorverzerrungsvorrichtung nach einem der Ansprüche 1 bis 9;
einem Leistungsverstärker (10) zum Verstärken eines durch die Vorverzerrungsvorrichtung vorverzerrten Übertragungssignals (S1'); und
einem dem Leistungsverstärker (10) nachgeschalteten Bandpaßfilter (12), dessen Durchlaßband auf den Nutzfrequenzbereich (60) des Übertragungssignals eingestellt ist.

11. Verfahren zur Vorverzerrung eines über eine nichtlineare Übertragungsstrecke zu übertragenden Übertragungssignals, mit folgenden Schritten:
Erzeugen eines Fehlersignals (S2') aus dem zu übertragenden Übertragungssignal (S1) und einer vorab erfaßten Übertragungscharakteristik der nichtlinearen Übertragungsstrecke (10), wobei das Fehlersignal (S2') eine Abschätzung eines durch die Nichtlinearität der Übertragungsstrecke (10) erzeugten Fehlers darstellt;
Bewirken einer zeitlichen Aufweitung des Fehlersignals (S2') zum Erzeugen eines Korrektursignals (S3);
Kombinieren des Korrektursignals (S3) und des zu übertragenden Übertragungssignals (S1) zum Erzeugen eines vorverzerrten Übertragungssignals (S1'),
wobei durch die zeitliche Aufweitung des Fehlersignals (S2') bewirkt wird, daß ein Fehlersignalanteil (50, 52) in dem Frequenzspektrum eines von der nichtlinearen Übertragungsstrecke (10) übertragenen Übertragungssignals (S4) von dem Nutzfrequenzbereich (60) des Übertragungssignals weg verschoben wird.

12. Verfahren zur spektralen Formung eines Störspektrums eines Übertragungssignals am Ausgang eines Leistungssenders, mit folgenden Schritten:
Vorverzerren des über eine nichtlineare Übertragungsstrecke zu übertragenden Übertragungssignals gemäß Anspruch 11, wobei die nichtlineare Übertragungsstrecke ein Leistungsverstärker ist; und
Zuführen des vorverzerrten Übertragungssignals (S1') zu dem Leistungsverstärker.

13. Verfahren nach Anspruch 12, das ferner den Schritt des Durchführens einer Bandpaßfilterung eines von dem Leistungsverstärker ausgegebenen Ausgangssignals (S4) aufweist.

## Claims

1. A device for predistorting a transmission signal (S1) to be transmitted over a nonlinear transmission path (10), comprising:
an estimator (14, 16) for determining an error signal (S2') depending on the transmission signal (S1) and a previously registered transfer characteristic of the nonlinear transmission path (10), where the error signal (S2') represents an estimate of an error generated due to the nonlinearity of the transmission path (10);
a time-dispersive element (18) for generating a correction signal (S3) by a temporal extension of the error signal (S2'); and
a combiner for combining the transmission signal (S1) and the correction signal (S3),
wherein, due to the temporal extension of the error signal (S2'), an error signal segment (50, 52) in the frequency spectrum of a transmission signal (S4) transmitted by the nonlinear transmission path (10) is shifted away from the useful frequency range (60) of the signal.

2. A device according to claim 1, wherein the nonlinear transmission path (10) is a power amplifier.

3. A device according to claim 1 or 2, wherein the estimator (14, 16) has a unit (30) for forming the squares of the magnitudes of the transmission signal (S1) to be transmitted and a table (32) for supplying complex distortion coefficients, which depend on the squares of the magnitudes and on the previously registered transfer characteristic of the nonlinear transmission path (10).

4. A device according to claim 3, wherein the unit (30) for forming the squares of the magnitudes of the real and the imaginary part of the transmission signal is provided.

5. A device according to claim 1 or 2, wherein the estimator has an envelope detector for detecting the envelope of the transmission signal, a quantizer for forming quantized envelope values and a table unit for supplying complex distortion coefficients which depend on the quantized envelope values and on the previously registered transfer characteristic of the nonlinear transmission path.

6. A device according to one of the claims 3 to 5, wherein the estimator also includes a unit for combining the squares of the magnitudes or of the envelope values and the complex coefficients for generating the error signal (S2').

7. A device according to one of the claims 1 to 6, wherein the time-dispersive element (18) is a time-dispersive bandpass filter or low-pass filter.

8. A device according to claim 7, wherein an adapter (22) is provided which, on the basis of a signal to be transmitted and an output signal output by a nonlinear transmission path (10) if there is no predistortion, ascertains the transfer characteristic of the nonlinear transmission path (10) and uses this to control the estimator and/or the filter coefficients of the time-dispersive bandpass filter or low-pass filter (18).

9. A device according to claim 8, wherein the adapter (22) ascertains the transfer characteristic at predetermined times.

10. A high-frequency transmitter comprising:
a predistorter according to one of the claims 1 to 9;
a power amplifier (10) for amplifying a transmission signal (S1') which has been predistorted by the predistorter; and
a bandpass filter (12) which succeeds the power amplifier (10) and whose transmission band is adjusted to the useful frequency range (60) of the transmission signal.

11. A method for predistorting a transmission signal to be transmitted over a nonlinear transmission path, comprising the following steps:
generating an error signal (S2') from the transmission signal (S1) to be transmitted and a previously registered transfer characteristic of the nonlinear transmission path (10), wherein the error signal (S2') represents an estimate of an error generated due to the nonlinearity of the transmission path (10);
effecting a temporal extension of the error signal (S2') to generate a correction signal (S3);
combining the correction signal (S3) and the transmission signal (S1) to be transmitted to generate a predistorted transmission signal (S1'),
wherein, due to the temporal extension of the error signal (S2'), an error signal segment (50, 52) in the frequency spectrum of a transmission signal (S4) transmitted by the nonlinear transmission path (10) is shifted away from the useful frequency range (60) of the transmission signal.

12. A method for spectrally forming an interference spectrum of a transmission signal at the output of a power transmitter, comprising:
predistorting the transmission signal as claimed in claim 11 which is to be transmitted via a nonlinear transmission path, the nonlinear transmission path being a power amplifier; and
feeding the predistorted transmission signal (S1') into the power amplifier.

13. A method according to claim 12, which also includes the step of performing bandpass filtering of an output signal (S4) output by the power amplifier.

## Revendications

1. Dispositif pour effectuer une prédistorsion d'un signal de transmission (S1) à transmettre sur une ligne de transmission non-linéaire (10), aux caractéristiques suivantes :
un dispositif d'évaluation (14, 16), destiné à déterminer un signal d'erreur (S2') fonction du signal de transmission (S1) et d'une caractéristique de transmission préalablement détectée de la ligne de transmission non-linéaire (10), le signal d'erreur (S2') représentant une estimation d'une erreur générée par la non-linéarité de la ligne de transmission (10) ;
un élément dispersif dans le temps (18), destiné à générer un signal de correction (S3) par un élargissement dans le temps du signal d'erreur (S2') ; et
un dispositif de combinaison, destiné à combiner le signal de transmission (S1) et le signal de correction (S3),
par l'élargissement dans le temps du signal d'erreur (S2') étant obtenu qu'une partie de signal d'erreur (50, 52) dans le spectre de fréquences d'un signal de transmission (S4) transmis par la ligne de transmission non-linéaire (10) est déplacée en direction s'éloignant de la zone de fréquences utile (60) du signal.

2. Dispositif selon la revendication 1, dans lequel la ligne de transmission non-linéaire (10) est un amplificateur de puissance.

3. Dispositif selon la revendication 1 ou 2, dans lequel le dispositif d'évaluation (14, 16) présente un dispositif d'élévation au carré de quantités (30) destiné à former des valeurs d'élévation au carré de quantités du signal de transmission (S1) à transmettre et un tableau (32) destiné à fournir des coefficients de distorsion complexes qui sont fonction des valeurs d'élévation au carré de quantités et de la caractéristique de transmission préalablement détectée de la ligne de transmission non-linéaire (10).

4. Dispositif selon la revendication 3, dans lequel le dispositif d'élévation au carré de quantités (30) est prévu pour élever au carré les quantités de la partie réelle et de la partie imaginaire du signal de transmission.

5. Dispositif selon la revendication 1 ou 2, dans lequel le dispositif d'évaluation présente un détecteur de courbe enveloppante destiné à détecter la courbe enveloppante du signal de transmission, un dispositif de quantification destiné à former des valeurs de courbe enveloppante quantifiées et un dispositif de tableau destiné à fournir des coefficients de distorsion complexes qui sont fonction des valeurs de courbe enveloppante quantifiées et de la caractéristique de transmission préalablement détectée de la ligne de transmission non-linéaire.

6. Dispositif selon l'une des revendications 3 à 5, dans lequel le dispositif d'évaluation présente, par ailleurs, un dispositif de combinaison des valeurs d'élévation au carré de quantités ou des valeurs de courbe enveloppante et des coefficients complexes, destiné à générer le signal d'erreur (S2').

7. Dispositif selon l'une des revendications 1 à 6, dans lequel l'élément dispersif dans le temps (18) est un filtre passe-bande ou un filtre passe-bande dispersif dans le temps.

8. Dispositif selon la revendication 7, dans lequel est prévu un dispositif d'adaptation (22) qui, sur base d'un signal à transmettre et d'un signal de sortie sorti par une ligne de transmission non-linéaire (10), lorsqu'il n'est pas effectué de prédistorsion, détermine la caractéristique de transmission de la ligne de transmission non-linéaire (10) et, sur base de celle-ci, commande le dispositif d'estimation et/ou les coefficients de filtre du filtre passe-bande ou filtre passe-bas dispersif dans le temps (18).

9. Dispositif selon la revendication 8, dans lequel le dispositif d'adaptation (22) détermine la caractéristique de transmission à des moments prédéterminés.

10. Emetteur haute fréquence, aux caractéristiques suivantes :
un dispositif de prédistorsion selon l'une des revendications 1 à 9 ;
un amplificateur de puissance (10) destiné à amplifier un signal de transmission (S1') prédistorsionné par le dispositif de prédistorsion ; et
un filtre passe-bande (12), connecté après l'amplificateur de puissance (10), dont la bande de passage est réglée à la plage de fréquences utiles (60) du signal de transmission.

11. Procédé pour effectuer une prédistorsion d'un signal de transmission à transmettre sur une ligne de transmission non-linéaire, aux étapes suivantes consistant à :
générer un signal d'erreur (S2') à partir du signal de transmission à transmettre (S1) et d'une caractéristique de transmission préalablement détectée de la ligne de transmission non-linéaire (10), le signal d'erreur (S2') représentant une estimation d'une erreur générée par la non-linéarité de la ligne de transmission (10) ;
réaliser un élargissement dans le temps du signal d'erreur (S2') pour générer un signal de correction (S3) ;
combiner le signal de correction (S3) et le signal de transmission à transmettre (S1), pour générer un signal de transmission prédistorsionné (S1'),
par l'élargissement dans le temps du signal d'erreur (S2') étant obtenu qu'une partie de signal d'erreur (50, 52) dans le spectre de fréquences d'un signal de transmission (S4) transmis par la ligne de transmission non-linéaire (10) est déplacée en direction s'éloignant de la zone de fréquences utile (60) du signal.

12. Procédé pour la formation spectrale d'un spectre de perturbation d'un signal de transmission à la sortie d'un émetteur de puissance, aux étapes suivantes consistant à :
effectuer une prédistorsion du signal de transmission à transmettre sur une ligne de transmission non-linéaire selon la revendication 11, la ligne de transmission non-linéaire étant un amplificateur de puissance ; et
amener le signal de transmission prédistorsionné (S1') à l'amplificateur de puissance.

13. Procédé selon la revendication 12, présentant, par ailleurs, l'étape consistant à effectuer une filtration passe-bande d'un signal de sortie (S4) sorti par l'amplificateur de puissance.
